# EUROPEAN PATENT APPLICATION

(11) **EP 0 562 848 A2**
(43) Date of publication of application: **29.09.1993**
(21) Application number: 93302258.4
(22) Date of filing: 24.03.1993
(51) Int. Cl.: H01L 21/306, C23F 1/00, H01L 21/00, H01L 21/316

(54) **Surface treating method**

(30) Priority: 27.03.1992 JP 70595/92
(71) Applicant: HITACHI, LTD., Chiyoda-ku, Tokyo 101 (JP)
(72) Inventor: Ono, Tetsuo, A-3, Hitachi-Tennoue-Shataku, Kokubunji-Shi, Tokyo (JP); Hiraoka, Susumu, Hitachi-Dai2-Kyoshin-Ryo, Kokubunji-Shi, Tokyo (JP); Suzuki, Keizo, Kodaira-Shi, Tokyo (JP)
(74) Representative: Paget, Hugh Charles Edward

(57) **Abstract**

Disclosed is a surface treating method of irradiating a beam of energy particles on a solid surface for forming an extremely thin compound film thereon, and then removing the compound film from the solid surface, thereby making it possible to etch the solid surface in order of atomic layer. For example, one or several atomic layers on the solid surface are selectively oxidized, and the resultant oxide film is removed from the solid surface. By repeating such processes, it is possible to etch the solid surface in order of atomic layer. The oxidation of the solid surface is performed, for example, by supplying an oxygen molecule thermally excited on the solid surface. The removal of the oxide film from the solid surface is performed, for example, by supplying a hydrogen fluoride (HF) gas on the oxidized solid surface. Since the interface between a semiconductor substrate and the oxide film formed on the surface thereof is made sharp in the atomic scale, it is possible to etch the solid surface in order of atomic layer by repeating the surface oxidation and the removal of the oxide film according to the above method.

## Description

### BACKGROUND OF THE INVENTION

The present invention relates to a fabrication method of fine structures on a solid surface, and particularly to a method of etching a solid surface in an amount of the order of one or a few atomic layers (herein called "in order of atomic layer").

Recently, along with the tendency toward refinement and diversification of semiconductor devices, the manufacturability in order of atomic layer has been required in an etching process constituting a part of semiconductor device fabrication processes. Namely, there have been such requirements that the solid surface after etching is free of damage and is flat in order of atomic layer, or that the vertical etch depth can be controlled in order of atomic layer.

To meet the above requirements, there are processes known the prior art, for example, disclosed in Japanese Patent Laid-open No. hei 1-289121. In the prior art, a semiconductor to be etched is first kept in low temperatures for permitting chlorine to be absorbed on the surface, and subsequently the temperature is increased to evaporate and remove only semiconductor surface layer (one monolayer) combined with the absorbed chlorine. By repeating such an operation, the surface of the semiconductor is etched, one monolayer at a time. Also, Japanese Patent Laid-open No. hei 3-110844 discloses that the surface of the semiconductor is etched, one monolayer at a time by repeating the processes of supplying a halogen gas such as chlorine and of irradiating a beam of charged particles (or beam of photons). In these ways the formation of a chloride on the solid surface and the removal of the chloride from the solid surface are paired with each other to form an etching cycle in order of atomic layer. This is advantageous in that the etching depth can be controlled in order of atomic layer by changing the number of the etching cycles.

Also, there is disclosed a process related to the present invention in Japanese Patent Laid-open No. sho 63-140535. This is characterized by first oxidizing the solid surface by heating, and then removing the oxide generated by the oxidation by reaction with an HF vapor, thereby making it possible to etch the solid surface with low damage. As similar art, in Japanese Patent Laid-open Nos. sho 61-183923 and hei 1-107545, there has been described the method that a Si surface is thermally oxidized (or chemically oxidized in nitric acid) to be a thickness of from several tens to several thousands Å, and the resultant oxide film is then removed by an HF solution. Further, Japanese Patent Laid-open No. sho 61-113775 discloses a process of oxidizing the solid surface.

In the above etching methods using a chlorine gas described in Japanese Patent Laid-open Nos. hei 1-289121 and hei 3-110844, since the chlorine is absorbed only on the first layer of the solid surface, it is impossible to etch the solid surface one monolayer at a time by each etching cycle, which causes such a disadvantage that the etching rate cannot be increased. Also, a problem is encountered in contamination inside a vacuum vessel caused by the chlorine. Further, the etching rate is greatly affected by the contamination on the surface of the semiconductor. For example, when the surface is contaminated by oxygen, carbon, metal and the like, the etching rate is reduced at the contaminated portion, which makes it impossible to obtain the flat surface. Accordingly, the etching in the process is performed in a high vacuum vessel. However, the chlorine corrodes the metal to produce the high volatile chloride, and is easily diffused in the interior of the metal. This brings such problems that the inner surface of the vacuum vessel is corroded by the chlorine, to cause the contamination, and that the semiconductor is etched by the remaining chlorine.

In the methods described in Japanese Patent Laid-open Nos. sho 63-140535, sho 61-183923 and hei 1-107545, it is impossible to etch the solid surface in order of atomic layer. This is because it is impossible to form an extremely thin oxide film in one or several atomic layers by the methods of oxidizing the solid surface used in the above arts (namely, a method of thermally oxidizing the solid surface by increasing the temperature up to several hundreds or chemically oxidizing the solid surface in a solution such as nitric acid).

### SUMMARY OF THE INVENTION

It is therefore an object of the present invention to provide a surface treating method capable of etching a solid surface in order of atomic layer (in order of one or several atomic layers) without bringing the problem of contamination inside a vacuum vessel as in the prior art and of suitably controlling the number of the atomic layers to be etched by one etching cycle within the range from one atomic layer to several atomic layers.

According to the present invention, there is provided a method of etching a solid surface in order of atomic layer by sequentially repeating the steps of first forming a stable compound layer of an oxide, nitride or the like in one or several monolayers on the solid surface, and then removing the compound layer from the solid surface.

In the above, by irradiating a beam of low energy particles including photons on the surface of a solid substrate, it is possible to enhance the formation rate of the above compound, and hence to increase the etching rate up to the practical level.

In addition, the formation of an oxide film in a monolayer scale on a solid surface can be obtained by, for example, supplying heated oxygen at the solid surface. Also, the removal of the formed oxide film can be performed by, for example, irradiating a vapor phase hydrogen fluoride (HF gas) on the solid surface.

According to the above method of the present invention, the following functional effect can be obtained. Namely, while a metal oxide or metal nitride is formed inside a vacuum vessel by introducing an oxygen gas or nitrogen gas, the vapor pressures of the metal oxide or the metal nitride is significantly lower than that of the metal chloride, so that there is never brought a problem of causing the contamination on the surface of the material to be etched by the oxide or nitride formed inside the vacuum vessel. Also, the interface between the solid substrate (material to be etched such as a metal and semiconductor) and the oxide film or nitride film formed on the surface thereof is significantly sharp, and accordingly the surface of the solid substrate after removing the film becomes flat in the atomic level. Thus, by repeating the processes of forming the stable compound layer of the oxide and nitride in one or several atomic layers on the surface of the solid substrate, and of removing the stable compound layer, it is possible to perform the preferable etching in atomic layer scale. In addition, if the thickness of the compound layer formed on the surface of the solid substrate becomes too large , it is difficult to remove them. Accordingly, preferably, the thickness of the stable compound layer is substantially within the range of from one to five atomic layers. Also, in formation of the compound on the surface of the solid substrate, the compound layer can be grown at a low sample temperature by supplying other energy different from the thermal energy. Further, the formation rate of the compound can be controlled by changing the amount of the supplied energy, which makes it possible to form the extremely thin compound layer.

The formation process of the above compound film will be described in detail by way of the example of forming an oxide film on the surface of a silicon (Si) substrate. In order to oxidize the extremely thin layers (several atomic layers) of the surface of the solid substrate, there is required a method of controlling the oxidation rate in the region where the oxidation rate is very slow. First, this will be described.

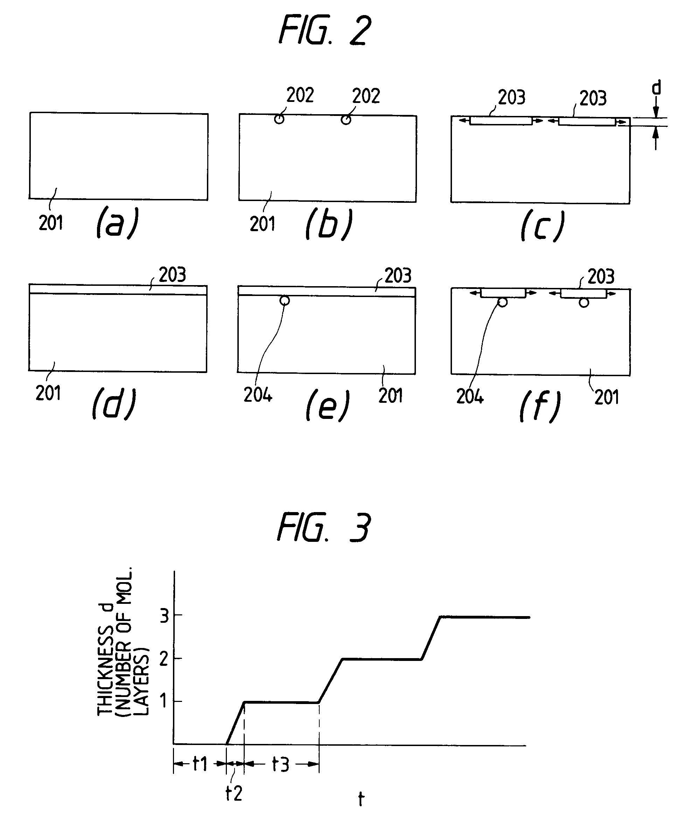

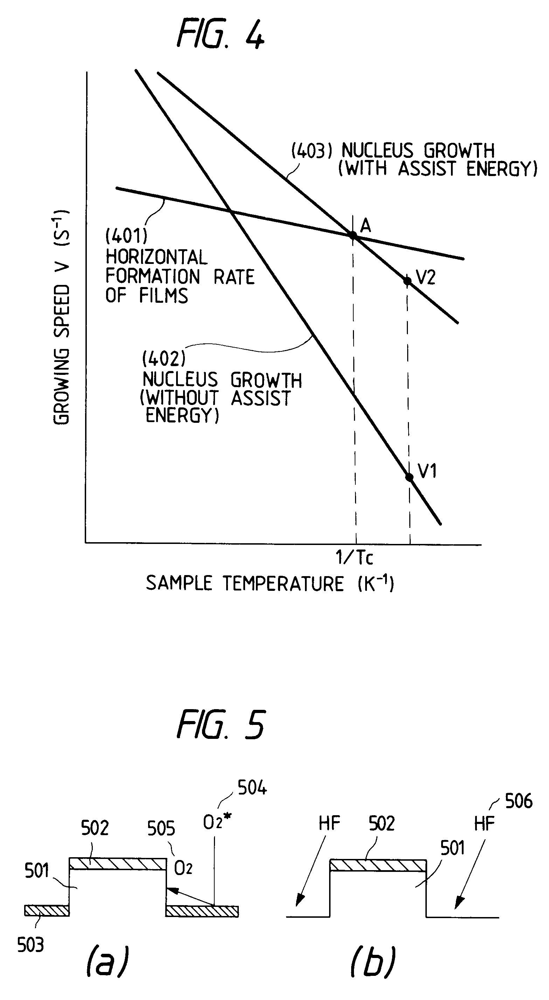

Figs. 2(a) to 2(f) show the state where the oxide film is grown on the surface of a sample (Si) 201. When the sample 201 having the clean surface as shown in Fig. 2(a) is exposed to oxygen or water vapor, each nucleus 202 for oxidation reaction is formed as shown in Fig. 2(b). This seems to be dependent on the absorption of the oxygen on the point defect present on the surface of the sample. When the nucleus 202 is perfectly formed, the potential energy in the peripheral portion thereof becomes high, and the growth of an oxide film 203 in the horizontal direction is rapidly started as shown in Fig. 2(c). Here, in the case that the temperature of the sample 201 is low, a first layer oxide film is first formed as shown in Fig. 2(d), and subsequently, the formation of a second layer nucleus 204 is started as shown in Fig. 2(e). On the other hand, in the case that the sample temperature is high, as shown in Fig. 2(f), the second layer nucleus 204 is formed before the first layer is perfectly formed, so that the growth of the oxide film becomes rapid, which makes it impossible to stop the growth the oxide film at the several monolayers. Accordingly, in order to etch the sample 201 in atomic layer scale, there is required to realize the condition of growing the oxide film one monolayer at a time as shown in Figs. 2(d) and 2(e). A relationship between the thickness of the oxide film and the oxidation time in the above is shown in Fig. 3. In this figure, t1 is a time required for formation of the first layer reaction nucleus 202 as shown in from Fig. 2(a) to Fig. 2(b); t2 is a time required for formation of the first oxide film as shown in from Fig. 2(c) to Fig. 2(d); and t3 is a time required for formation of the second reaction nucleus 204 as shown in Fig. 2(e). If the growth of the oxide film is steppedly progressed one monolayer at a time described above, it is possible to etch the surface of the sample 201 in order of a suitable number of atomic layers, by stopping the growth of the oxide film at the time when it reaches a thickness of a suitable number of monolayers, and by removing the oxide film.

In addition, it is required to control each of the necessary times t1, t2 and t3 within the practical time. For example, in the case that Si subjected to an HF treatment is left at room temperature in air, it takes about 7 days to grow the first layer oxide film, thereby making it difficult to obtain the practical etching rate. The times t1, t2 and t3 can be shorten by increasing the temperature of the sample; however, with an increase in the temperature, the oxidation rate is rapidly increased, and is difficult to be controlled. Also, in the case that the device is already formed on the sample, the sample temperature cannot be increased, which makes it impossible to perform the etching at a practical rate.

To cope with the above inconvenience, in the present invention, there is provided an etching method comprising the steps of previously thermally exciting a reactive material (for example, oxygen) which is reacted with a sample material and generates the compound, and then supplying it on the sample surface; or giving a low energy in the degree not to damage the sample, for example, irradiating photons on the sample surface during the reaction between the above reactive material and the sample material; thereby making it possible to grow the compound film at the lower sample temperature, and hence to control the formation rate of the compound film. Hereinafter, the above function will be described with reference to Fig. 4.

Fig. 4 shows a relationship among the sample temperature, the formation rate of reaction nucleus and the horizontal film formation growth rate. In this figure, the abscissa indicates the sample temperature in terms of the inverse number of the sample temperature (K). Also, the ordinate indicates the growth rate, wherein the growth rate of nucleus is indicated by the inverse number (1/t1) of the nucleus formation necessary time t1, and the film formation rate is indicated by the inverse number (1/t2) of the film formation necessary time t2. As shown in this figure, the growth rate is in the approximately linear relation (Arrhenius' relation) to the sample temperature, wherein the gradient indicates the apparent activation energy. By giving the energy during the reaction of film formation, the apparent activation energy is effectively reduced, and the nucleus formation rate becomes small in its gradient as shown in from a straight line 403 with assist energy to a straight line 402 without assist energy in Fig. 4. Under the condition that the sample temperature is kept constant, the growth rate of nucleus is increased by giving the energy as shown in from V1 to V2 in Fig. 4. Also, when the sample temperature is changed, the change in the growth rate of nucleus becomes moderate in the case with assist energy (straight line 403) as compared with the case without assist energy (straight line 402). This means that the control of the growth rate of nucleus or the film formation rate is made easy. In addition, at a point A where the straight line 401 showing the film formation rate intersects the straight line 403 showing the growth rate of nucleus in Fig. 4, t1 is made to be equal to t2. The right side from the point A defines a region of t2 <t1. In this region of t2 <t1 in the right side from the point A (namely, the region where the sample temperature is less than T_{C}), the compound film is formed while giving the energy differently from the thermal energy on the surface of the sample (namely, as in the state of the straight line 403), which makes it possible to enhance the film formation rate, and further to easily control the film formation rate.

Next, the removal of the compound film (oxide film) formed on the surface of the sample is performed by supplying a vapor phase hydrogen fluoride (HF gas) on the surface of the sample. The method makes it possible to remove the oxide film with high selectivity just as the general method for removing the oxide film by a liquid phase hydrogen fluoride. Namely, only the oxide film formed on the surface of the semiconductor is etched, and the portion which is not oxidized is not etched. By use of the vapor phase hydrogen fluoride (HF), it is possible to remove the oxide film within the vacuum vessel.

By combination of the formation and removal of the compound film (oxide film) described above, it is possible to etch the surface of the sample in order of atomic layer without exposing the sample to the atmosphere. Namely, it is possible to etch and remove one or several atomic layers from the surface of the sample by one etching cycle of the processes of forming the oxide film one time and of removing the oxide film one time.

### BRIEF DESCRIPTION OF THE DRAWINGS

Fig. 1A is a view showing a basic construction of an etching apparatus for carrying out an etching process of the present invention;
Fig. 1B is a view for explaining a timing of supplying an O₂ gas and an HF gas on the surface of the sample in the apparatus as shown in Fig 1A;
Figs. 2(a) to 2(e) are typical views for explaining the basic principle of the etching method of the present invention;
Fig. 3 is a view showing a relationship between the thickness "d" of the oxide film formed on the surface of the sample and the time "t" in the etching method of the present invention;
Fig. 4 is a view showing a relationship between the growth rate of the oxide film formed on the surface of the sample and the sample temperature;
Fig. 5 is a sectional typical view of a sample showing the state where the vertical etching is achieved in the etching method of the present invention;
Figs. 6 to 12 are views showing other construction forms of an etching apparatus used for carrying out the etching method of the present invention;
Figs. 13(a) to 13(d) are sectional typical views of a semiconductor device for explaining the preparation of the semiconductor device using the etching method of the present invention;
Fig. 14 is a view showing the schematic construction of the apparatus in which the etching method of the present invention is applied to the surface analysis;
Figs. 15(a) to 15(b) are views for explaining the preparation of the sample to be observed by a transmission electron microscope using the etching method of the present invention; and
Figs. 16(a) to 16(c) are sectional typical views of a quantum wire device for explaining the state where the electrode is mounted on the quantum wire device using the etching method of the present invention.

### DESCRIPTION OF PREFERRED EMBODIMENTS

Hereinafter, embodiments of the present invention will be described in detail with reference to the accompanying drawings.

### (Embodiment 1)

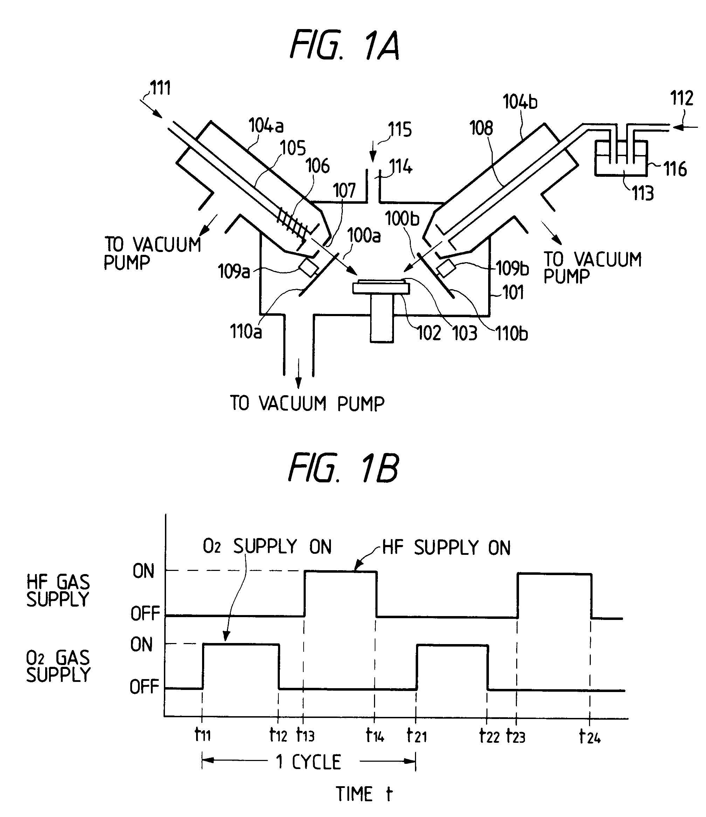

Fig. 1A shows a basic construction of an etching apparatus used for carrying out an etching method of the present invention. A sample 103 to be etched is placed on a sample holder 102 in a reaction chamber 101. The sample 103 is, for example, made of a semiconductor such as Si or GaAs. An O₂ molecular beam chamber 104a and an HF beam chamber 104b are provided in the reaction chamber 101.

An oxygen gas flow 111 is introduced in the O₂ molecular beam chamber 104a through a nozzle 105. The nozzle 105 is made of quartz, ceramics, metal and the like, and has an inside diameter, preferably, of from 1 to 10mm. A heater 106 for heating the leading edge portion of the nozzle 105 is provided in the beam chamber 104a. An oxygen gas molecule passing through the nozzle 105 is thermally excited by the heater 106. The heater 106 is, for example, constituted of a tungsten wire wound around the leading edge of the nozzle 105. The oxygen gas molecule thermally excited by the heater 106 is expanded in the reaction chamber 101 evacuated through a pinhole 107, and is incident on the surface of the sample 103 as an oxygen molecular beam 100a. If the oxygen molecule thus thermally excited collides with another molecule before reaching the surface of the sample, it reverts to the ground state again. Accordingly, the beam chamber 104a and reaction chamber 101 are evacuated so that the mean free path of the oxygen molecule is made larger than the distance between the leading edge of the nozzle 105 and the surface of the sample 103. Also, by differential pumping the insides of the reaction chamber 101 and beam chamber 104a through the pinhole 107, it is possible to prevent contaminants from being carried out from the heater 106 in high temperatures to the surface of the sample 103.

Also, an HF gas flow 100b is produced by supplying a carrier gas 112 such as a rare gas into a hydrofluoric acid 113 filled in a teflon made tank 116, and which is supplied to the surface of the sample 103 through a nozzle 108 in the HF beam chamber 104b. In addition, a heater (not shown) is provided in the sample holder 102 for heating the sample 103.

The oxygen molecular beam 100a and HF beam 100b are mechanically chopped by rotation of the choppers 110a and 110b through motors 109a and 109b, respectively. Each of the choppers 110a and 110b is, for example, formed of a disk being made of quartz, metal or the like and having an opening (slit) through which a beam passes. Only the beam passing through each slit reaches the surface of the sample 103.

Hereinafter, there will be described a method for etching the surface of the sample 103 in order of atomic layer using the apparatus having the construction described above. Fig. 1B shows a timing with which the O₂ molecular beam 100A and the HF beam 100b are alternately supplied on the surface of the sample 103. First, at a time t₁₁, the chopper 110a is opened to supply ("on" in Fig. 1B) the oxygen molecular beam 100a on the surface of the sample for oxidizing the surface of the sample. At this time, the chopper 110b is closed to stop ("off" in Fig. 1B) the supply of the HF gas on the surface of the sample. The oxygen molecular beam to be supplied on the surface of the sample has a high energy than the oxygen in the usual ground state because the vibrational state thereof is mainly excited by heating through the heater 106. The oxidation rate on the surface of the sample is increased by the assist energy, thereby realizing such a state as shown in a straight line 403 of Fig. 4. For example, under the condition that the flow rate of the oxygen gas: 4sccm (4cc of the oxygen gas flows in 1 minute in the standard state), the sample temperature: 440°C, the temperature in the vicinity of the outlet of the nozzle 105: 820°C, the extremely thin oxide film of three monolayers is stably formed for 30 minutes.

When the oxide film of the desired thickness is thus formed, the chopper 110a is closed at a time t₁₂, to stop ("off" in Fig. 1B) the supply of the oxygen molecular beam 100a. Subsequently, the chopper 110b is opened at a time t₁₃, to supply ("on" in Fig. 1B) the HF gas on the surface of the sample for removing the oxide film previously formed. The method for removing the oxide film using the HF gas is high in the selectivity, which makes it possible to selectively remove only the oxide film formed previously (between t₁₁ to t₁₂). After the completion of the removal of the oxide film, the chopper 110b is closed at a time t₁₄, to stop ("off" in Fig. 1B) the supply of the HF gas, thus terminating the etching at a first cycle.

For further increasing the etching depth on the surface of the sample, there may be repeated such a cycle that the oxygen molecular beam is supplied for a time between t₂₁ and t₂₂ to oxide the surface of the sample, after which the HF gas is supplied for a time between t₂₃ and t₂₄ to remove the oxide film. By repeating such etching cycle by plural times, it is possible to perform the etching up to a suitable depth in order of atomic layer. For example, the sample 103 is etched by three atomic layers at one cycle under the previous oxidation condition. In addition, the number of the atomic layers etched at one cycle is widely controlled by changing the above oxide film formation times (t₁₁ to t₁₂ and t₂₁ to t₂₂) through adjustment of the magnitude of the beam passing opening (slit) of the chopper 110a and the rotational speed of the chopper 110a, or changing the sample temperature and the nozzle heating temperature. Also, in the case of repeating plural etching cycles, the number of the atomic layers etched in each cycle may not be made identical to each other. For example, the surface of the sample is often contaminated at the beginning of the etching, and in this case, it is desired that several atomic layers on the surface of the sample are etched at a time by first one cycle to remove the contaminated layers, and each atomic layer is etched at a time from the next cycle. This is easily realized, for example, by changing the rotational speed of the chopper 110a for each cycle, to thereby change the supply time of the oxygen molecular beam 100a or the oxide film formation time. Also, in the case of etching a large sample, it is desired that the sample holder 102 is rotated or moved.

In the method of thermally (by heating) exciting the oxygen molecular beam, the kinetic energy of the oxygen molecular beam after being excited is approximately leV or less, which is sufficiently smaller than the bond energy of a semiconductor (Si: 3.3eV, GaAs: 4.7eV), thereby never damaging the internal structure of the sample. Namely, the oxygen molecular beam never yields the disorder or the like of the lattice on the surface of the sample, thereby making it possible to obtain the etching surface excellent in the flatness. Accordingly, the energy given to the oxygen molecular beam for improving the oxidation rate on the surface of the sample must be within such a magnitude as not to give the damage on the surface of the sample.

Also, according to the etching method using the oxygen beam thermally excited described above, it is possible to perform the so-called anisotropic etching. Hereinafter, this anisotropic etching will be described. Fig. 5 typically shows the sectional state of a sample 501 on the way of etching. A part of the surface of the sample 501 is covered with a mask 502. The anisotropic etching means the etching of the sample in the direction perpendicular to the surface of the sample along the peripheral edge of the mask. In this case, in the apparatus having the construction as shown in Fig. 1, the installation position of the beam chamber 104a and the beam incident direction are set in such a manner that the oxygen molecule supplied on the surface of the sample 103 as the oxygen molecular beam 100a is incident in the direction perpendicular to the surface of the sample, or the sample holder 102 is tilted to satisfy the same condition. As shown in Fig. 5(a), an oxygen molecule (O₂ *) 504 thermally excited is incident in the direction perpendicular to the surface of the sample, to form an oxide film 503. A part 505 of non-reacted oxygen molecule (O₂) reflected by the surface of the sample collides with the side wall of the sample covered with the mask 502. In the fabrication method of the present invention, as described above, the temperature of the sample 501 is low, and accordingly the thermally excited oxygen molecule (O₂*) collides with the surface of the sample and loses the excitation energy, to be thus dropped in the original ground state. Namely, the oxidation rate at the side wall portion of the sample by the oxygen molecule (O₂) which is reflected by the surface of the sample and is incident on the side wall of the sample is made significantly smaller than the oxidation rate at the surface portion the sample on which the thermally excited oxygen molecule (O₂*) is directly incident. Accordingly, the above side wall portion is little oxidized within a time for which several atomic layers on the surface portion of the sample are oxidized, and the oxide film of several atomic layers is formed thereat. Subsequently, as shown in Fig. 5(b), when an HF gas 506 is irradiated on the surface of the sample, only the oxide film 503 formed on the surface portion of the sample is etched and removed, and the side wall portion of the sample is never etched, as a result which the etching is advanced in the direction perpendicular to the surface of the sample along the peripheral edge of the mask 502 as shown in Fig. 5(b).

Also, in the apparatus having the construction as shown in Fig. 1, when the temperature of the heater 106 is increased, thermally dissociated oxygen atom (O) is generated, other than the thermally excited oxygen molecule. In this case, the oxidation rate on the surface of the sample is made significantly rapid , and accordingly the control of the oxidation rate becomes difficult. In this case, however, by cooling the sample 103 at an extremely low temperature using a liquid nitrogen or the like, it is possible to stably form the extremely thin oxide film of several monolayers at one time just as in the case described above.

### (Embodiment 2)

Next, there will be described a method for oxidizing the surface of the sample in order of atomic layer by giving the thermal energy to a gas molecule differently from the oxygen molecule to be supplied on the surface of the sample for oxidizing the surface of the sample using the apparatus having the construction as shown in Fig. 1A. In this method, an oxygen gas 115 is directly introduced from an inlet 114 in the reaction chamber 101 as the oxygen molecule in the ground state. Alternatively, for increasing the oxidation rate on the surface of the sample, for example, a gas 111 being chemically stable such as chloro-fluoro-carbons and carbon dioxide is heated (thermally excited) through the nozzle 105 to be supplied on the surface of the sample 103. This method makes it possible to realize the oxidation film formation in the stepped state as shown in Fig. 3, and to control the oxidation rate at the actual rate.

### (Embodiment 3)

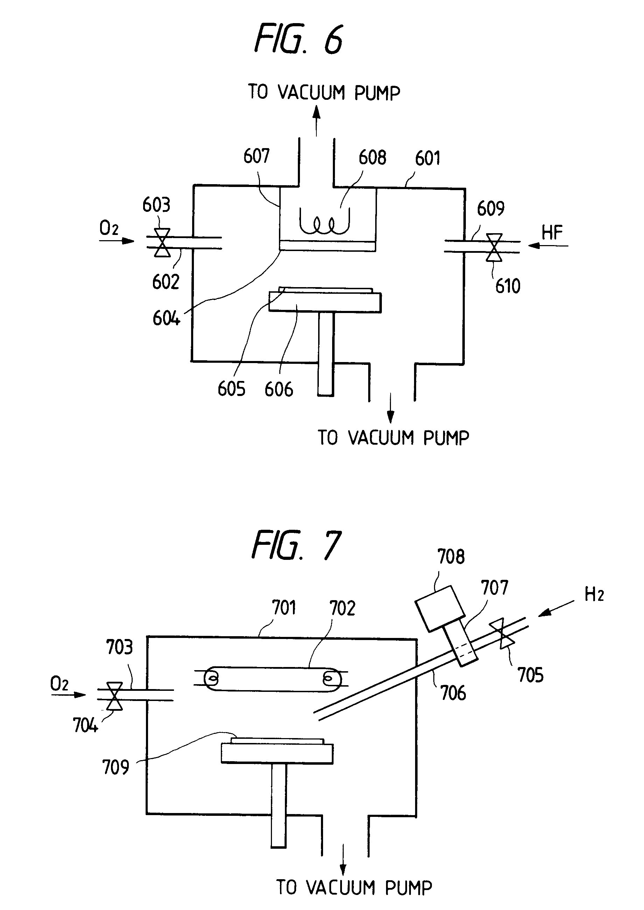

Fig. 6 shows another embodiment of the method for heating the oxygen gas molecule (thermally exciting method). An oxygen gas molecule is introduced as an atmosphere from an inlet 602 within a reaction chamber 601. An activation plate 604 is disposed in the reaction chamber 601 in such a manner as to be parallel to the surface of a sample 605 placed on a sample holder 606. The activation plate 604 is heated from the back surface thereof by a heater 608. For preventing the contamination of the surface of the sample due to contaminants from the heater, a space for containing the sample 605 is partitioned from a space for containing the heater 608 by a partition 607. The respective spaces are independently evacuated. The oxygen molecule collided with the activation plate 604 is thermally excited in the same manner as in Embodiment 1, to be incident on the surface of the sample 605. According to this method, by enlarging the size of the activation plate 604 so as to cover the surface of the sample 605, it is possible to effectively perform the oxidation for the surface of a large sample such as a Si wafer having a diameter of, for example 200mm. This heating method using the activation plate is the same in principle as the nozzle type described in Embodiment 1, and which makes it possible to form the extremely thin film with high repeatability. In addition, it is required to keep the degree of vacuum within the reaction chamber 610 in such a manner that the mean free path of the oxygen molecule thermally excited by the activation plate 604 is made longer than the distance between the activation plate 604 and the sample 605.

After formation of the oxide film, a valve 603 is closed, and a valve 610 is then opened, to introduce an HF gas from an inlet 609. In this embodiment, the HF gas is directly introduced as an atmosphere in the reaction chamber 601 without the carrier gas used in the previous embodiments, to remove the oxide film formed on the surface of the sample. By use of solenoid valves as the valves 603 and 610, it is possible to rapidly switch the gases to be introduced.

By repeating the etching cycle of processes of forming the oxide film and of removing the oxide film, it is possible to accurately etch the surface of the sample in order of atomic layers.

In addition, even with use of the apparatus having the construction that a plurality of beam sources each being constituted of the heater wound around the nozzle are juxtaposed in such a manner as to cover the whole surface of the large sample, it is possible to etch the surface of the large sample just as the case using the apparatus as shown in Fig. 6.

### (Embodiment 4)

Fig. 7 shows a further embodiment of the present invention. In this embodiment, ultraviolet rays are used to increase the oxidation rate on the surface of the sample, and atomic hydrogen is used to remove the oxide film. First, a valve 704 is opened to introduce an oxygen gas from an inlet 703 in a reaction chamber 701. At the same time, an ultraviolet ray lamp 702 is operated . By the energy of ultraviolet rays from the lamp, the oxidation rate on the surface of the sample 709 is increased to realize the state as shown in the straight line 403 of Fig. 4, thus forming a thin oxide film on the surface of the sample. In this case, the oxidation rate can be controlled by changing the intensity of the ultraviolet rays and the concentration of the oxygen.

Next, the valve 704 is closed, and the valve 705 is opened to introduce a hydrogen gas. Here, a microwave energy is used to generate an atomic hydrogen. An inlet 706 for introducing the hydrogen gas is fluidly communicated to the reaction 701 through a waveguide 707. A microwave generated in a magnetron 708 is supplied in the waveguide 707. The inlet 706 is made of quartz or ceramics for transmitting the microwave from the magnetron therethrough. Accordingly, there is generated a microwave discharge inside the portion of the inlet 706 passing through the inside of the waveguide 707. By the microwave discharge, the introduced hydrogen gas molecule is excited, to generate the atomic hydrogen (excited hydrogen molecule or atom). The oxide film on the surface of the sample is removed by the atomic hydrogen. The selectivity of the etching (removal of the oxide film) by the atomic hydrogen is made high, so that only the oxide film on the surface of the sample is effectively etched and the portion which not oxidized is never etched.

By repeating the formation and removal of the oxide film described above, it is possible to etch the surface of the sample in order of atomic layer. By making longer the size of the inlet 706 to some extent or more, the charges generated by the discharge are recombined with each other and dissipated on the inner surface of the inlet prior to reaching the surface of the sample, thereby making it possible to prevent the electrification on the surface of the sample. Also, it is possible to separate and remove the charged particles generated by the discharge through the electric filed prior to reaching the surface of the sample. In addition, during the supply of the atomic hydrogen on the surface of the sample, the ultraviolet ray lamp 702 may be left as being lightened.

The atomic hydrogen described above may be generated by thermally exciting the hydrogen molecule in the same manner as the method for heating the oxygen molecule in Embodiment 1.

### (Embodiment 5)

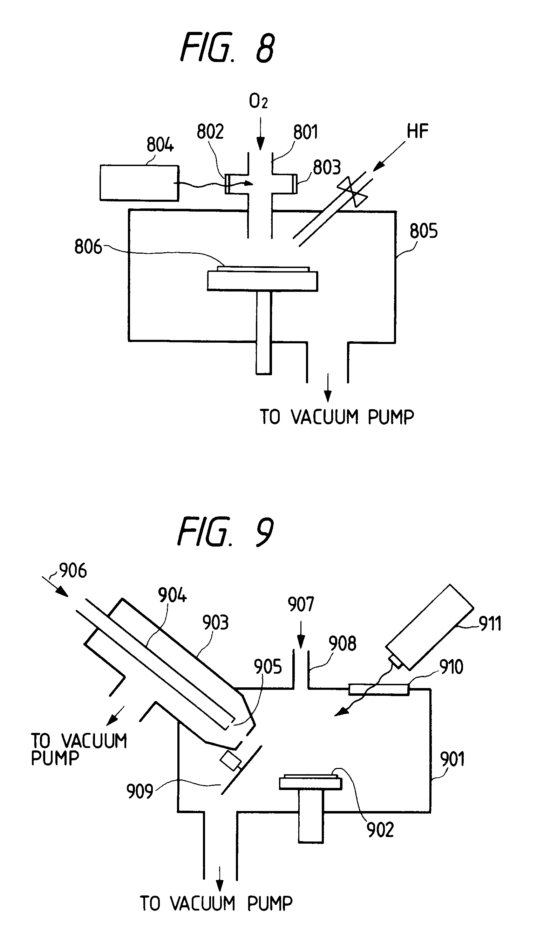

Fig. 8 shows a method of vibrationally exciting the oxygen molecule for oxidation on the surface of the sample by a laser beam. As shown in this figure, on the way of an inlet 801 for introducing the oxygen gas, a half mirror 802 and a mirror 803 are mounted. The laser beam from a laser beam source 804 is introduced in the inlet 801 through the half mirror 802, and is irradiated to the oxygen gas molecule in the inlet while being frequently reciprocated between the half mirror 803 and the mirror 802, to vibrationally excite the oxygen gas molecule effectively. The wavelength of the beam capable of vibrationally exciting the oxygen gas molecule is 6.4µm, which can be obtained by a solid state laser, for example, using AG₃AsS₃. The oxygen molecule thus excited by the laser beam is introduced in a reaction chamber 805, to oxidize the surface of a sample 806. This method makes it possible to oxidize the surface of the sample in order of atomic layer. The removal of the oxide film is made using an HF gas or the like in the same manner as in previous embodiments.

### (Embodiment 6)

Fig. 9 shows a still further embodiment of the present invention. In this embodiment, the oxidation on the surface of the sample is promoted by a seeding method, and the removal of the oxide film is made using an ultraviolet ray laser. The seeding method is to mix a heavy gas molecule such as oxygen in a light gas molecule such as helium, and hence to increase the translational energy of the heavier gas molecule (oxygen). By enhancing the translational energy of the oxygen molecule supplied on the surface of the sample using the seeding method, it is possible to oxidize the surface of the sample in order of atomic layer.

In this figure, a reaction chamber 901 is mounted with a beam chamber 903 for generating the oxygen molecule beam. An introducing gas 906 is introduced in a nozzle 904 provided in the beam chamber 903. As the introducing gas, there is used a helium gas mixed with an oxygen gas in an amount of several vol%. According to the principle of the above seeding method, the oxygen gas molecule introduced in the nozzle 904 collides with the helium gas molecule, thus to become excited in translational energy.The excited oxygen gas molecule is expanded in the beam chamber 903 through an expanding port 905, to be incident on the surface of the sample 902 as a molecular beam. In this seeding method, it is required to increase the number of collisions between the gas molecules, namely, to increase the pressure in the nozzle 904), and accordingly the expanding port 905 is formed to be extremely small in the inside diameter of from several µm to several hundreds µm. Needless to say, the interior of the beam chamber 903 is differential-pumped. By supplying the excited oxygen gas molecule on the surface of the sample, the surface of the sample can be oxidized in order of atomic layer.

The starting and the ending of the oxidation is carried out by chopping the oxygen molecule beam directed from the nozzle 904 to the surface of the sample 902 by a chopper 909. First, the chopper 909 is opened, and the oxygen molecule beam is supplied on the surface of the sample 902, to oxidize the surface of the sample. Next, the chopper 909 is closed and an excimer laser 911 is operated. The ultraviolet rays from the excimer laser 911 are incident on the surface of the sample 902 through a window 910 made of calcium fluoride or the like. The oxide film on the surface of the sample can be selectively removed by the irradiation of such ultraviolet rays, which makes it possible to etch the surface of the sample in order of atomic layer. Also, by introducing a hydrogen gas molecule in the reaction chamber 901 during the removal of the oxide film, it is possible to increase the removing rate of the oxide film.

Also, in the apparatus having the construction as shown in Fig. 9, as another form, the oxygen gas 907 is directly introduced from the inlet 908 in the reaction chamber 901, and a mix gas 906 of a helium gas mixed with a rare gas such as krypton in an amount of several % is introduced in the nozzle 905 to give the energy of promoting the oxidation on the surface of the sample, so that the heavier rare gas is supplied on the surface of the sample 902 as a molecular beam.

Further, for removal of the oxide film on the surface of the sample, aside from the ultraviolet rays from the excimer laser 911, there may be used an X-ray from a SR source (Synchrotron Resonance).

### (Embodiment 7)

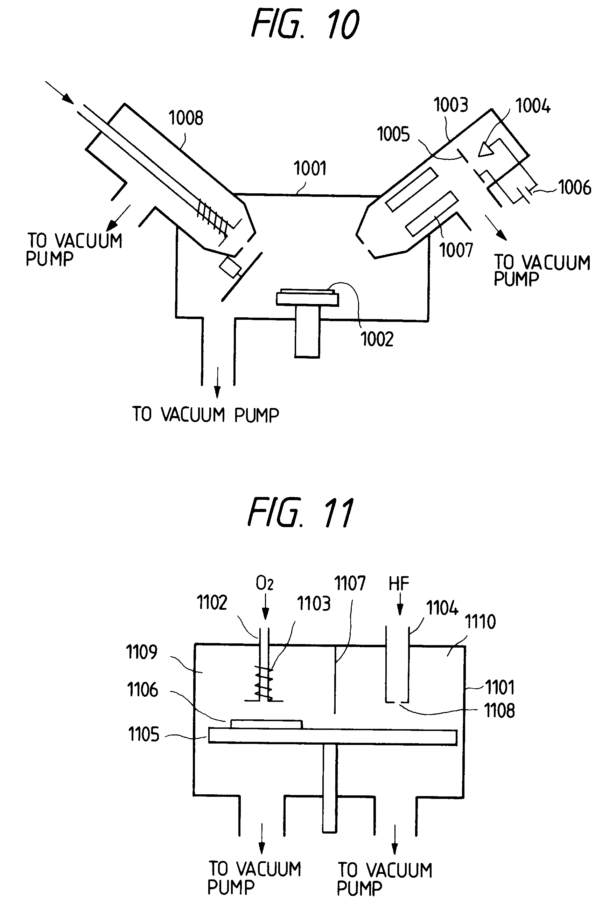

Fig. 10 shows an embodiment wherein the oxide film on the surface of the sample is removed using an electron beam. A beam chamber 1008 and an electron beam chamber 1003 are mounted in a reaction chamber 1001 which contains a sample 1002. Here, the construction of the beam chamber 1008 is the same as the case shown in Fig. 1A. The electron beam for removing the oxide film is generated by applying an extraction voltage from a power supply 1006 between an electron source 1004 as a cathode and an extraction electrode 1005 as an anode. The generated electron beam is controlled in its beam diameter and its beam direction by a control electrode system 1007 constituted of an electron lens and deflection electrode, to be thus irradiated on the surface of the sample. By irradiating the electron beam on the oxide film formed on the surface of the sample by the previous oxidation treatment, the irradiated oxide film is selectively removed. This method is advantageous in that, since the diameter of the electron beam is made extremely smaller, and the direction thereof can be precisely controlled, it is possible to selectively remove the oxide film formed on the arbitrary portion of the surface of the sample. By removing the oxide film on the surface of the sample using this method, it is possible to etch the arbitrary portion of the surface of the sample in order of atomic layer without any mask.

### (Embodiment 8)

Fig. 11 shows another method of performing the switching between the formation and removal of the oxide film. For oxidation on the surface of the sample (formation of the oxide film), there is used an oxygen molecule thermally excited by heating in a nozzle 1102. The nozzle 1102 is heated by a heater 1103. For removal of the oxide film from the surface of the sample, there is used an HF gas or a mixed gas of the HF gas and a water vapor (H₂O). An expanding hole 1108 having a diameter of several µm to several hundreds µm is provided on the leading edge of a nozzle 1104. With this construction, the pressure in the nozzle 1104 is made sufficiently high, which makes it possible to form the HF beam with the translational energy sufficiently enhanced.

A reaction chamber 1101 is partitioned into an oxidation section 1109 and an oxide film removal section 1110 by a partition wall 1107. A sample 1106 is placed on a turn table 1105. By rotation of the turn table 1105, the sample 1106 is first carried in the oxidation section 1109, wherein the oxidation is performed on the surface of the sample in order of atomic layer by the excited oxygen molecule. Subsequently, by rotation of the turn table 1105, the sample 1106 is carried in the oxide film removal section 1110, wherein the removal of the oxide film is performed by the excited HF gas. In this method, by placing a plurality of samples on the turn table 1105 and sequentially moving them between both the sections, it is possible to continuously etch them without stopping the supply of the oxygen molecule and HF gas, which makes it possible to significantly improve the efficiency.

### (Embodiment 9)

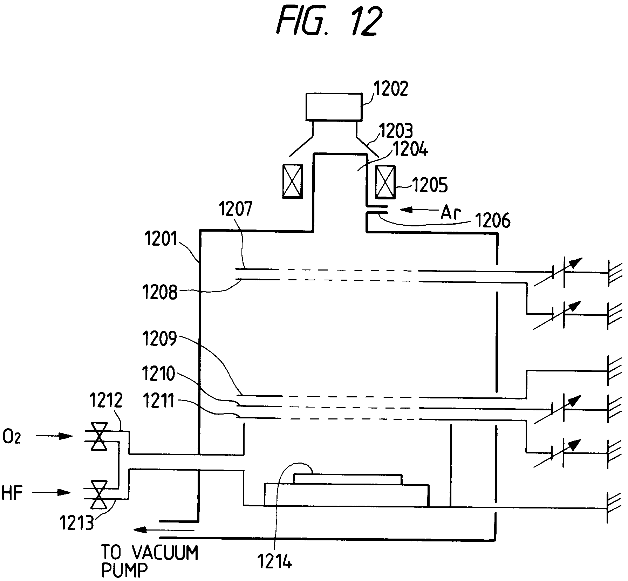

Fig. 12 shows a method of giving the energy for promoting the oxidation by an electrically neutral beam with high velocity. A plasma generating unit 1204 constituted of a quartz tube or the like in a reaction chamber 1201. A microwave is introduced from a magnetron 1202 in the plasma generating unit 1204 through a waveguide 1203. A rare gas such as argon is introduced from a gas inlet 1206, to generate a microwave discharge plasma in the plasma generating unit 1204. A magnet 1205 is intended to correct the orbits of ions and electrons in the plasma, and to prevent the recombination thereof at the chamber wall. The argon positive ions generated thereat are accelerated between a mesh electrode 1207 (positive voltage) and a mesh electrode 1208 (negative electrode). On the other hand, there exit a lot of neutral argon atoms not ionized in the plasma generating unit 1204 within the reaction chamber 1201. It is well known that some of the accelerated argon positive ions collide with these neutral argon atoms and receive the electrons, and are neutralized themselves to become a neutral beam of atoms. The thus neutral beam of atoms with high velocity is incident on the surface of a sample 1214, to give the energy for promoting the oxidation on the surface of the sample. Mesh retarding electrodes 1209, 1210 and 1211 are provided over the whole surface for removing the electrons and ions damaging the sample.

For oxidation on the surface of the sample, in the state where the above Ar atom beam with high velocity is incident on the surface of the sample, the oxygen gas is introduced from a gas inlet 1212 in the reaction chamber 1201. Consequently, the oxidation is promoted by the kinetic energy of the Ar atom beam with high velocity. Thus, the oxidation rate becomes the state as shown in a straight line 403 of Fig. 4, and the oxide film is formed in a monolayer scale within the practical time. Subsequently, the introduction of the oxygen gas is stopped, and the removal of the oxide film previously formed is performed by introducing the HF gas through an inlet 1213. At this time, the supply of the Ar neutral beam of atoms on the surface of the sample may be stopped or not be stopped. By alternately repeating the above oxide film formation process and the oxide film removal process, it is possible to etch the surface of the sample in order of atomic layer.

The above embodiments have described that the oxide film is formed on the surface of the sample using the oxygen molecule, and subsequently the oxide film is removed, to thereby etch the surface of the sample. However, various modifications may be used. For example, in formation of the oxide film on the surface of the sample, aside from the above oxygen molecule, the molecule containing the oxygen such as water (H₂O) may be used. Also, it is possible that a nitride film is formed on the surface of the sample using a molecule containing an N₂ molecule or NO molecule, and then the nitride film is removed, to thereby etch the surface of the sample. Further, by using hydrogen fluoride (HF) or a mixed gas of nitric acid (HNO₃) and the same, the nitride film can be effectively removed.

### (Embodiment 10)

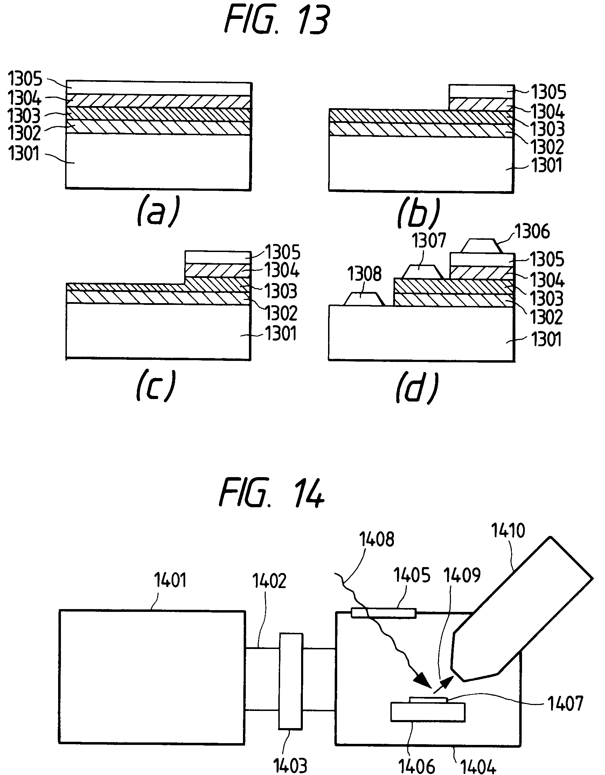

Hereinafter, an embodiment regarding the application of the present invention will be described. Fig. 13 shows a sectional structure of a semiconductor device known as a heterojunction bipolar transistor. For fabrication of this device, as shown in Fig. 13 (a), a collector layer 1302 made of a n-type GaAs, a base layer 1303 made of a p+-type GaAs, an emitter layer 1304 made of a n-type AlGaAs, and a cap layer 1305 made of a n+-type GaAs are growth on a substrate 1301 made of a semi-insulating GaAs by a molecular beam epitaxy method or the like. The thickness of the substrate 1301 is about several hundreds µm, and the thickness of each layer is several hundreds Å. Next, as shown in Fig. 13 (b), each of the cap layer 1305 and the emitter layer 1304 is removed by etching while remaining a part thereof. While being omitted in this figure, naturally, the etching is performed after forming a mask on the cap layer 1305 by lithography. The dry etching using the conventional plasma makes it impossible to accurately control the etching depth, and hence to accurately stop the etching directly over the base layer 1303, as s result of which the base layer 1303 is over-etched by a depth of several Å as shown in Fig. 13(c). Further, the over-etching depth of the base layer 1303 is greatly varied, thereby causing the distribution in the cut-off frequency of the device.

On the contrary, since the etching in order of atomic layer according to the present invention can control the etching depth in order of atomic layer (several Å), it is possible to accurately stop the etching at the upper surface of the base layer 1303 as shown in Fig. 13(b). The etching is performed by repeating the cycle of first oxidizing the surface of the layer to be etched, and then removing the surface oxide film generated by the oxidation, for example, using the apparatus as shown in Fig. 1A. The oxygen molecule is used for oxidation, and the HF gas is used for removal of the oxide film. For example, by repeating the etching cycle of oxidizing the cap layer (GaAs) and the emitter layer (AlGaAs) by four atomic layers at a time and of removing the generated oxide film, it is possible to perform the etching of a thickness of 5.7Å per one cycle in the case of (100) face. For example, in the case that each of the cap layer and the emitter layer is 250Å, by repeating the above cycle by 88 times, it is possible to accurately stop etching at the state where the base layer 1303 is removed (over-etched) by 1.6Å. The over-etching amount is extremely small and the distribution thereof is never present, which exerts no effect on the characteristic of the device, thus making it possible to obtain the characteristic of device with no distribution. Naturally, by etching one atomic layer per one cycle on the way of the etching, it is possible to eliminate the over-etching of the base layer 1303. After the cap layer 1305 and the emitter layer 1304 are etched described above (see Fig. 13 (b)), the base layer 1303 and collector layer 1302 are partly etched. Then, electrodes 1306, 1307 and 1308 are finally provided as shown in Fig. 13(d), to thus form the device. According to the prior art, even in the etching of the base layer and the collector layer, the substrate 1301 is over-etched by several tens Å; however, according to the present invention, it is possible to accurately stop the etching at the uppermost surface of the substrate 1301.

### (Embodiment 11)

Fig. 14 shows an embodiment in which the present invention is applied on a solid surface analysis. In the apparatus as shown in this figure, an etching chamber 1401 and an analysis chamber 1404 are connected to each other through a connection section 1402 having a valve 1403. The etching chamber 1401 and the analysis chamber 1404 are independently evacuated by the separated vacuum pumping systems (not shown). Also, for example, a sample 1407 can be reciprocated between both chambers by a sample transfer means (not shown) such as a belt. The apparatus in the etching chamber 1401 is, for example, so constructed as in Fig. 1A. It is possible to perform the surface analysis of the sample 1407 by X ray photoelectron spectroscopy in the analysis chamber 1404. In the X ray photoelectron spectroscopy, an X ray 1408 having the energy of about 100eV is irradiated on the surface of the sample, and the energy of a photoelectron 1409 from the surface of the sample is analyzed by an energy analyzer 1410, to thus analyze the component atoms on the surface of the sample and the binding states thereof. The X ray 1408 is incident in the analysis chamber 1404 through a window 1405 made of beryllium or the like.

First, the spectroscopic analysis for the surface of the sample is carried out in the the analysis chamber 1404 by the X ray photoelectron spectroscopy. Next, the sample 1407 is carried in the etching chamber 1401, and the surface of the sample is etched by one atomic layer according to the method as described in Embodiment 1. At this time, for preventing the contamination within the energy analyzer 1410, the valve 1403 is closed. After etching, the valve 1403 is opened, and the sample is carried in the analysis chamber 1404 again, wherein the spectroscopic analysis for the surface of the sample is performed again. The analysis information thus obtained is related to the state where only one atomic layer on the surface of the sample is removed. Consequently, by comparing this information with the previous one, it is possible to analyze the atom constituting the top surface of the sample.

By repeating the etching and the analysis on the surface of the sample, it is possible to analyze the exact depth profile of atomic distribution regarded as impossible by the conventional X ray photoelectron analysis.

In addition, according to the present invention, as the method for analyzing the surface of the sample, aside from the above X ray photoelectron spectroscopy, there can be used the Auger electron spectroscopy, extended X ray absorption fine structure (EXAFS) and the like.

### (Embodiment 12)

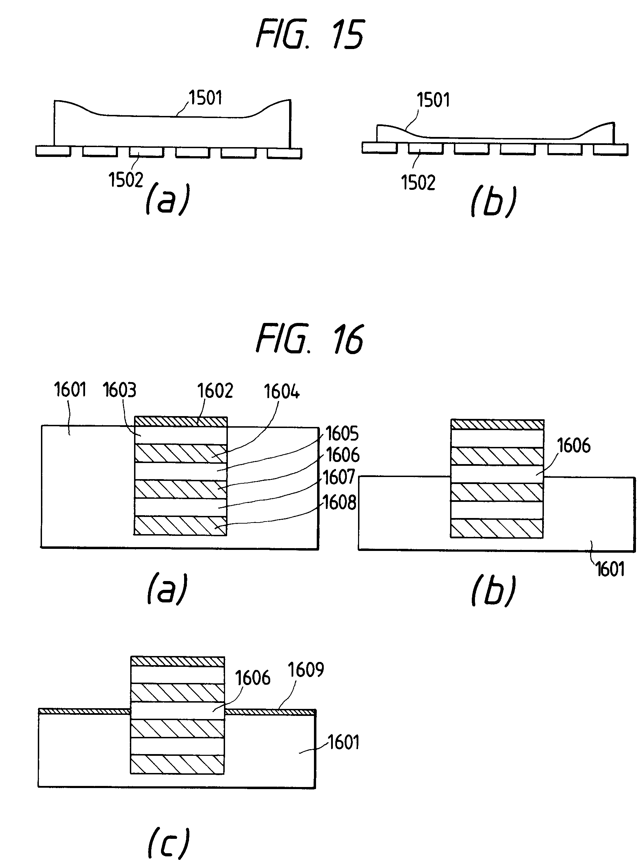

Fig. 15 shows an embodiment in which the present invention is applied to the sample preparation for a transmission electron microscopy (hereinafter, referred to as TEM). In the TEM, an electron is required to pass through a sample, so that the sample must be formed to be a thickness of several ten Å or less. Conventionally, there have been used a technique of thinning the sample by mechanically grinding and wet-etching it. However, the wet etching makes it difficult to control the thickness, and has a fear of etching the portion to be observed, which brings a difficulty in preparing the sample.

Fig. 15(a) shows the state where a sample 1501 mechanically ground to be thinned to some extent is placed on a mesh 1502 made of copper or the like serving as a sample holder of the TEM. In this embodiment, in such a state, the surface of the sample is etched using an apparatus as shown in Fig. 1A. In the etching, the thickness of the sample is measured prior to the etching, and the sample is etched by a specified amount at one time using the etching method of the present invention, or is etched to be a specified thickness by alternately repeating the etching and the measurement of the thickness. Thus, it is possible to easily prepare the sample with a thickness of several Å as shown in Fig. 15(b). In the etching method using the apparatus as shown in Fig. 1A, the sample is never damaged, so that it is possible to obtain the exact information regarding the sample in observation by the TEM.

### (Embodiment 13)

Fig. 16 is an embodiment in which the etching method of the present invention is applied to the preparation of the quantum wire. The quantum wire being the sample has such a structure that a multi-layer composed of AlGaAs layers 1603, 1605, 1607 and GaAs layers 1604, 1606 and 1608 is buried in a part of a substrate 1601 made of high resistance Si or the like. The thickness of each layer is within the range of from several Å to several tens Å. The above structure of the quantum wire is often used in a semiconductor laser or the like. Here, a method for mounting electrodes on a specified layer will be described. First, a resist 1602 is coated on a portion to which a multi-layer is buried. Subsequently, the substrate portion around the the multi-layer is etched using the apparatus as shown in Fig 1A. Assuming that the thickness of each layer of the multi-layer is 10Å, by etching the substrate by only 12 to 14 atomic layers from the surface, it is possible to stop the etching in such a state that the GaAs layer 1606 is just exposed as shown in Fig. 16(b). Next, as shown in Fig. 16(c), a thin film electrode 1609 made of a low resistance material such as metal is formed on the substrate 1601 by molecular beam epitaxy. Thus, the fabrication of electrodes to the GaAs layer 1606 is terminated.

As described above, the method of etching the peripheral portion while remaining a specified portion of the interior of the sample, thereby exposing the specified portion on the surface can be effectively applied to measurement (analysis) and fabrication of a micro portion of the interior of the sample.

## Claims

1. A surface treating method comprising:
a step of irradiating a beam of energy particles on a solid surface for forming a compound film thereon; and
a step of removing said compound film from said solid surface.

2. A surface treating method according to claim 1
wherein said compound film formed on said solid surface comprises a plurality of layers;
said step of forming said compound film on said solid surface including at least forming a first reactive nucleus for forming a first layer of said compound film on said solid surface, and growing said first layer of said compound film in parallel to said solid surface on the basis of said first reactive nucleus; and
a relation of t2<t1 is satisfied, where t1 is a time required for formation of said first reactive nucleus and t2 is a time required for growth of said first layer of said compound film.

3. A surface treating method according to claim 1 or 2, wherein said compound film formed on said solid surface comprises an oxide film or a nitride film.

4. A surface treating method according to any one of claims 1 to 3 wherein said beam of energy particles is obtained by thermally exciting an oxygen molecule, a nitrogen molecule or the other molecule which reacts with said solid surface and forms the compound film.

5. A surface treating method according to any one of claims 1 to 3, wherein said beam of energy particles is obtained by thermally exciting a molecule containing an oxygen atom or oxygen, or a molecule containing a nitrogen atom or nitrogen.

6. A surface treating method according to claim 1 or 2, wherein said beam of energy particles comprises photons.

7. A surface treating method comprising alternately repeating a step of supplying a material which reacts with a solid surface and forms a compound film on said solid surface to form a compound film of one to five atomic layers on said solid surface, and a step of removing said compound film from said solid surface.

8. A surface treating method according to claim 7 wherein said compound film formed on said solid surface comprises an oxide film or a nitride film.

9. A surface treating method according to claim 7 or 8, wherein said step of forming said compound film on said solid surface is performed by thermally exciting a molecule to be reacted with said solid surface and to form a compound and supplying said molecule at said solid surface.

10. A surface treating method according to claim 7 or 8 wherein said step of forming said compound film on said solid surface comprises a process of forming an oxide or nitride film on said solid surface, which is performed by supplying thermally excited oxygen or nitrogen molecules respectively at said solid surface.

11. A surface treating method according to claim 7 or 8 wherein said step of forming said compound film on said solid surface is performed while irradiating photons on said solid surface.

12. A surface treating method according to claim 7 wherein said step of forming said compound film on said solid surface comprises forming an oxide or nitride film on said solid surface while irradiating photons on said solid surface.

13. A surface treating method according to any one of claims 1 to 12 wherein said step of removing said compound film comprises exposing said solid surface to a hydrogen fluoride gas or a hydrogen fluoride gas having a water content.

14. A surface treating method according to any one of claims 1 to 12 wherein said step of removing said compound film comprises irradiating atomic hydrogen at said solid surface.

15. A surface treating method according to any one of claims 1 to 12 wherein said step of removing said compound film comprises supplying thermally excited hydrogen gas at said solid surface.

16. A surface treating method according to any one of claims 1 to 12 wherein said step of removing said compound film comprises irradiating an electron beam, ultraviolet rays or X-rays onto said solid surface.
